# EUROPÄISCHE PATENTSCHRIFT

(11) **EP 2 329 510 B1**
(45) Veröffentlichungstag und Bekanntmachung des Hinweises auf die Patenterteilung: **13.11.2013**
(21) Anmeldenummer: 08802451.8
(22) Anmeldetag: 20.09.2008
(51) Int. Cl.: H01J 37/32, H01J 37/34

(54) **Plasmaleistungsversorgungsanordnung**
Plasma power supply arrangement
Dispositif d' alimentation en puissance pour plasmas

(43) Veröffentlichungstag der Anmeldung: 08.06.2011
(73) Patentinhaber: TRUMPF Hüttinger GmbH + Co. KG, 79111 Freiburg im Breisgau (DE)
(72) Erfinder: WIEDEMUTH, Peter, 79336 Herbolzheim (DE)
(74) Vertreter: Kohler Schmid Möbus
(86) Internationale Anmeldenummer: PCT/EP2008/007949
(87) Internationale Veröffentlichungsnummer: WO 2010/031421

(56) Entgegenhaltungen:
- EP-A- 1 589 793
- DE-A1- 10 260 726
- DE-A1-102006 057 529
- US-A- 4 924 170

## Beschreibung

Die Erfindung betrifft eine Plasmaleistuhgsversorungsanordnung mit mehreren Leistungsversorgungseinheiten, sowie ein Verfahren zum Betrieb einer Plasmaleistungsversorgungsanordnung mit mehreren Leistungsversorgungseinheiten.

Ein Beispiel für eine Plasmaleistungsversorgungsanordnung mit mehreren Leistungsversorgungseinheiten mit jeweils einem Wechselsignalerzeuger zeigt die D10 2006 057529 A1.

Bei Flatpaneldisplay (FPD) Herstellungsprozessen werden große Flächen von Substrat, z.B. Glasscheiben, gleichmäßig in mehreren Schritten beschichtet. Die Beschichtung von großen Glasflächen mittels Sputtern/ Kathodenzerstäuben in Plasmaprozessen, und zwar sowohl reaktiv als auch konventionell, ist aus der Architekturglasbeschichtung bekannt. Dazu wird mit einer Strom- oder Spannungsquelle ein Plasma erzeugt, das von einem Target Material abträgt, welches sich auf dem Substrat, z.B. der Glasscheibe, ablagert. Vor der Ablagerung können sich die Atome je nach gewünschter Beschichtung in einem reaktiven Prozess noch mit Gasatomen oder - molekülen verbinden.

Bei der Architekturglasbeschichtung werden die Glasscheiben in der Plasmakammer (Beschichtungskammer) kontinuierlich an einer Sputterquelle vorbeigeführt und wird die Beschichtung somit gleichmäßig aufgetragen. Dazu muss die Plasmaverteilung in nur einer Achse, also eindimensional, nämlich senkrecht zur Bewegungsrichtung des Substrats, homogen sein.

Bei der Architekturglasbeschichtung werden sowohl DC- als auch Mittelfrequenz (MF)-Sputterprozesse verwendet. Letztere werden mit (MF)-Leistungsversorgungseinheiten betrieben. Dabei wird aus einer Ein- oder Mehrphasenspannung eine geregelte oder ungeregelte Zwischenkreisspannung erzeugt. Die Zwischenkreisspannung wird mit einer Inverterschaltung (z.B. Brückenschaltung) zu einer Mittelfrequenz (MF)-Wechselspannung umgewandelt (10-500kHz). Das MF-Ausgangsleistungssignal wird auf einen Schwingkreis geschaltet, der zu einer Schwingung angeregt wird. Der Schwingkreis kann ein Serienschwingkreis oder ein Parallelschwingkreis sein. Ein Serienschwingkreis wird mit einem Ausgangsleistungssignal mit einer Spannungsquellencharakteristik angeregt, wohingegen der Parallelkreis mit einem Ausgangsleistungssignal mit einer Stromquellencharakteristik angeregt wird.

Üblicherweise wird die MF-Leistung, d. h. ein durch eine Leistungsversorgungseinheit generiertes Wechselsignal mit einer Frequenz im Bereich 10 - 500kHz, an der Spule des Schwingkreises ausgekoppelt und an zwei Elektroden in einer Beschichtungskammer einer Beschichtungsanlage angeschlossen, so dass in der Beschichtungskammer ein Plasma erzeugt werden kann. Die Elektroden arbeiten bei einem MF-Anregungssystem abwechselnd als Anode und Kathode.

Bei FPD-Herstellungsprozessen werden aufgrund ihrer Größe die Substrate flächig beschichtet, ohne dass die Substrate bewegt werden. Da ein relativ großes Substrat von einigen Quadratmetern bis zu mehreren 10qm in der vollen Fläche gleichzeitig beschichtet wird und die Ausfallrate sehr gering sein muss, da ein FPD nicht aus mehreren Teilen zusammengesetzt werden kann, ergeben sich neue Anforderungen an die Anlagen, an die Plasmakammern, Elektroden, Targets und letztlich auch an die Plasmaleistungsversorgungsanordnung.

Zur Beschichtung der gesamten Fläche in einem Arbeitschritt sind sehr viel höhere Leistungen pro Arbeitsschritt erforderlich als bei der Architekturglasbeschichtung. Die FPD-Herstellprozesse benötigen zur Plasmaerzeugung Leistungsversorgungseinheiten mit Leistungen von 50 bis 200kW und mehr. Dabei sollen die Leistungsversorgungseinheiten ohne großen Aufwand zwischen den einzelnen Leistungsklassen umkonfigurierbar sein, also z.B. von 50kW auf 100kW. Oftmals werden mehrere Targets in einer Plasmakammer von mehreren Leistungsversorgungseinheiten versorgt. Dabei ist es eine Herausforderung, die Leistung über die gesamte Fläche auch bei kurzzeitigen Unterbrechungen oder Leistungsschwankungen einzelner Leistungsversorgungseinheiten homogen zuzuführen.

Bei der Plasmabeschichtung kann es zu Überschlägen kommen, bei denen sich ein Strom einen elektrisch leitenden Kanal im Plasma sucht. Ursache hierfür ist der Umstand, dass neben dem Substrat selbst auch Teile der Plasmakammer, wie etwa deren Innenwand, mit elektrisch besonders schlecht leitenden Materialien beschichtet werden, die sich dann bis zu einem Durchbruchspanner auftaden. Derartige Überschläge müssen vermieden werden oder so schnell wie möglich gelöscht werden, wenn sie auftreten. Daher ist es bekannt, Arcerkennungseinrichtungen vorzusehen. Wenn nun für eine Leistungsversorgungseinheit, die mit einem Magnetron verbunden ist, festgestellt wird, dass ein Arc aufgetreten ist oder ein solcher zu befürchten ist, müssen enstprechende Gegenmaßnahmen eingeleitet werden, wie beispielsweise die Unterbrechung der Leistungszufuhr. Werden in einer großen Plasmakammer jedoch mehrere Magnetrons eingesetzt, so muss außerdem darauf geachtet werden, dass die Beschichtung des Substrats möglichst gleichmäßig erfolgt. Die durch die einzelnen Leistungsversorgungseinheiten gespeisten Plasmaprozesse sollten daher möglichst gleichmäßig ablaufen.

Aufgabe der vorliegenden Erfindung ist es, eine Plasmaleistungsversorgungsanordnung bereitzustellen, mit der eine möglichst homogene Beschichtung eines großen Substrats ermöglicht wird.

Gelöst wird diese Aufgabe durch eine Plasmaleistungsversorgungsanordnung mit mehreren Leistungsversorgungseinheiten, die jeweils umfassen:
a) einen Wechselsignalerzeuger,
b) einen Modulator, der ein von dem Wechselsignalerzeuger erzeugtes Wechselsignal mit zumindest einem Modulationssignal moduliert,
c) einen Modulationssignaleingang, der mit dem Modulator in Verbindung steht,
d) einen Modulationssignalausgang, der mit zumindest einem Modulationseingang einer anderen Leistungsversorgungseinheit in Verbindung steht.

Durch diese Maßnahme ist es möglich, dass die Wechselsignale, die in jeder Leistungsversorgungseinheit generiert werden, alle mit demselben Modulationssignal moduliert werden. Durch ein geeignetes Modulationssignal ist es zum einen möglich, die Ausgangsleistung der Leistungsversorgungseinheiten zu regeln bzw. zu steuern und zum anderen ist es möglich, ein Ausgangssignal der Leistungsversorgungseinheiten zu erzeugen, welches wiederholt und/oder für eine bestimmten Zeitraum keine Leistung oder nur eine geringe Leistung an den zugeordneten Plasmaprozess liefert. Somit kann beispielsweise das Entstehen von Arcs in der Plasmakammer reduziert oder vollständig vermieden werden.

Jede Leistungsversorgungseinheit kann einen eigenen Modulationssignalerzeuger aufweisen, der mit dem Modulationssignalausgang und/oder dem Modulator in Verbindung steht. Durch die Art und Weise, wie die Leistungsversorgungseinheiten miteinander verbunden sind, ist es außerdem möglich, dass von unterschiedlichen Leistungsversorgungseinheiten generierte Modulationssignale einander überlagert werden und somit ein Wechselsignal, welches in einer Leistungsversorgungseinheit generiert wird, mit mehreren Modulationssignalen moduliert wird.

Schwankt bei einer Leistungsversorgungseinheit die abgegebene Leistung, was die unterschiedlichsten Gründe haben kann, so kann der Modulationssignalerzeuger der Leistungsversorgungseinheit die anderen Leistungsversorgungseinheiten mit dieser Leistungsschwankung synchronisieren.

Es kann ein externer Modulationssignalgenerator vorgesehen sein, der mit dem Modulationssignaleingang mindestens einer Leistungsversorgungseinheit verbunden ist. Durch die Vorgabe eines externen Modulationssignals kann die Ausgangsleistung zumindest einer, vorzugsweise aller Leistungsversorgungseinheiten gesteuert werden.

Der Modulationssignalausgang und der Modulationssignaleingang einer Leistungsversorgungseinheit können in einer gemeinsamen Schnittstelle realisiert sein. Dadurch können Modulationssignaleingang und Modulationssignalausgang besonders einfach ausgestaltet und realisiert werden.

Die Wechselsignalerzeuger können als Freischwinger ausgebildet sein. Dies bedeutet, dass die Frequenz des Wechselsignals nicht extern vorgegeben wird sonder sich automatisch aufgrund der Dimensionierung der Bauteile des Schwingkreises einstellt. Dies bedeutet weiterhin, dass die Wechselsignale der einzelnen Leistungsversorgungseinheiten nicht miteinander synchronisiert sind. Durch die Verwendung eines Modulationssignal, das allen Leistungsversorgungseinheiten zugeführt wird, kann eine Synchronisation erfolgen. Insbesondere kann ein synchronisiertes An- und Ausschwingen der Ausgangssignale der Leistungsversorgungseinheiten realisiert werden, was zu einer gleichmäßigen Beschichtung führt.

Die Leistungsversorgungseinheiten können über die Modulationssignaleingänge und -ausgänge in Serie miteinander verbunden sein. Dies bedeutet eine einfache Verkabelung der Leistungsversorgungseinheiten. Auf die Veränderungen im Plasmaprozess kann schnell reagiert werden.

Die Leistungsversorgungseinheiten können einen Gleichspannungserzeuger aufweisen, zur Erzeugung einer Zwischenkreisspannung, an die die Wechselsignalerzeuger angeschlossen sind.

Jede Leistungsversorgungseinheit kann an eine Doppelkathodeneinheit angeschlossen sein. Doppelkathodeneinheiten sind besonders geeignet, große Substratflächen zu beschichten.

Weiterhin kann zumindest ein Modulationssingalerzeuger eine Arcerkennungseinrichtung umfassen oder mit einer solchen verbunden sein. Dadurch kann in Abhängigkeit von einem erkannten Arc oder einem bevorstehenden Arc ein Modulationssignal erzeugt werden und an zumindest eine andere Leistungsversorgungseinheit weitergegeben werden, sodass das Wechselsignal dieser oder beider Leistungsversorgungseinheiten entsprechend moduliert werden kann.

In den Rahmen der Erfindung fällt außerdem ein Verfahren zum Betrieb einer Plasmaleistungsversorgungsanordnung mit mehreren Leistungsversorgungseinheiten, wobei in jeder Leistungsversorgungseinheit
a) ein Wechselsignal erzeugt wird,
b) das erzeugte Wechselsignal mit zumindest einem Modulationssignal moduliert wird,
c) wobei als Modulationssignal ein in der jeweiligen Leistungsversorgungseinheit erzeugtes Modulationssignal und/oder ein extern erzeugtes Modulationssignal verwendet wird.

Die Leistungsversorgungseinheiten können so zusammengeschaltet werden, dass eine Leistungsversorgungseinheit einer anderen Leistungsversorgungseinheit ihr Modulationssignal aufzwingen kann und zusätzlich von extern ein Modulationssignal überlagert werden kann. Somit werden sämtliche Wechselsignale der Leistungsversorgungseinheiten synchron und mit denselben Modulationssignalen moduliert.

Dabei kann ein in einer Leistungsversorgungseinheit erzeugtes Modulationssignal zumindest einer anderen Leistungsversorgungseinheit zugeführt werden. Somit kann das Wechselsignal der Leistungsversorgungseinheit, in der das Modulationssignal erzeugt wurde, mit demselben Modulationssignal moduliert werden wie das Wechselsignal einer anderen Leistungsversorgungseinheit, der das Modulationssignal zugeführt wird. Dies führt zu einem gleichmäßigen Plasmabeschichtungsprozess.

Weiterhin kann vorgesehen sein, dass ein in einer Leistungsversorgungseinheit erzeugtes Modulationssignal allen anderen Leistungsversorgungseinheiten zugeführt wird, sodass alle Leistungsversorgungseinheiten mit demselben Modulationssignal moduliert werden.

Weiterhin kann vorgesehen sein, dass jede Leistungsversorgungseinheit ein Modulationssignal erzeugt, das jeweils allen anderen Leistungsversorgungseinheiten zugeführt wird. Somit kann jede Leistungsversorgungseinheit auf einen erkannten Arc reagieren und die anderen Leistungsversorgungseinheiten dazu zwingen, in gleichem Maße zu reagieren, um die Beschichtung des großflächigen Substrats einheitlich zu halten.

Dabei kann vorgesehen sein, dass in zumindest einer Leistungsversorgungseinheit ein moduliertes Ausgangssignal erzeugt wird, indem das Wechselsignal mit einem intern generierten und einem extern generierten Modulationssignal moduliert wird.

In jeder Leistungsversorgungseinheit kann eine Gleichspannung erzeugt werden, um dann ausgehend von der Gleichspannung ein Wechselsignal zu erzeugen. Vorzugsweise wird das Wechselsignal mit einem so genannten Freischwinger erzeugt.

Für einen großflächigen Plasmabeschichtungsprozess ist es vorteilhaft, wenn durch jede Leistungsversorgungseinheit ein Wechselsignal mit einer Frequenz im Bereich 10kHz bis 500kHz und einer Leistung >50kW erzeugt wird.

In jeder Leistungsversorgungseinheit kann ein Wechselsignal mit einer anderen Frequenz erzeugt werden. Dies kann unter anderem dadurch realisiert werden, dass in den Leistungsversorgungseinheiten Freischwinger verwendet werden.

In zumindest einer Leistungsversorgungseinheit kann eine Arcerkennung durchgeführt werden, sodass das Substrat vor Arcen geschützt werden kann.

Wie bereits erwähnt, kann außerhalb der Leistungsversorgungseinheiten ein Modulationssignal erzeugt werden und zumindest einer Leistungsversorgungseinheit zugeführt werden. Vorzugsweise wird das Modulationssignal seriell allen Leistungsversorgungseinheiten zugeführt, sodass alle Wechselsignale mit demselben Modulationssignal moduliert werden und dadurch eine Synchronsisation erfolgt. Insbesondere kann dadurch eine Leistungseinstellung erfolgen.

Weitere Merkmale und Vorteile der Erfindung ergeben sich aus der nachfolgenden Beschreibung von Ausführungsbeispielen der Erfindung, anhand der Figuren der Zeichnung, die erfindungswesentliche Einzelheiten zeigen und aus den Ansprüchen. Die einzelnen Merkmale können für sich oder zu mehreren in beliebiger Kombination bei einer Variante der Erfindung verwirklicht sein.

Bevorzugte Ausführungsbeispiele der Erfindung sind in der Zeichnung schematisch dargestellt und werden nachfolgend mit Bezug zu den Figuren der Zeichnungen näher erläutert. Es zeigen:
- Figur 1: eine schematische Darstellung einer Plasmaleistungsversorgungsanordnung;
- Figur 2: zwei Leistungsversorgungseinheiten, deren Modulationseinbzw. Modulationsausgang miteinander verbunden sind;
- Figur 3a: ein Wechselsignal einer ersten Leistungsversorgungseinheit mit einer ersten Frequenz;
- Figur 3b: ein Wechselsignal einer zweiten Leistungsversorgungseinheit mit einer zweiten Frequenz;
- Figur 4a: ein Modulationssignal;
- Figur 4b: das Wechselsignal der Figur 3a, das mit dem Modulationssignal der Figur 4a moduliert wurde;
- Figur 4c: das Wechselsignal der Figur 3b, das mit dem Modulationssignal der Figur 4a moduliert wurde;
- Figur 5a: ein alternatives Modulationssignal;
- Figur 5b: das Wechselsignal der Figur 3a, das mit dem Modulationssignal der Figur 5a moduliert wurde;
- Figur 5c: das Wechselsignal der Figur 3b, das mit dem Modulationssignal der Figur 5a moduliert wurde;
- Figur 6a: ein alternatives Modulationssignal;
- Figur 6b: das Wechselsignal der Figur 3a, das mit dem Modulationssignal der Figur 6a moduliert wurde;
- Figur 6c: das Wechselsignal der Figur 3b, das mit dem Modulationssignal der Figur 6a moduliert wurde;
- Figur 7a: ein alternatives Modulationssignal;
- Figur 7b: das Wechselsignal der Figur 3a, das mit dem Modulationssignal der Figur 7a moduliert wurde;
- Figur 7c: das Wechselsignal der Figur 3b, das mit dem Modulationssignal der Figur 7a moduliert wurde;
- Figur 8a: ein Modulationssignal, das sich durch Überlagerung der Modulationssignale der Figuren 4a und 5a zusammensetzt;
- Figur 8b: das Wechselsignal der Figur 3a moduliert mit dem Modulationssignal der Figur 8a;
- Figur 8c: das Wechselsignal der Figur 3b moduliert mit dem Modulationssignal der Figur 8a;
- Figur 9a: ein Modulationssignal, das sich durch Überlagerung der Modulationssignale der Figuren 4a und 6a zusammensetzt;
- Figur 9b: das Wechselsignal der Figur 3a moduliert mit dem Modulationssignal der Figur 9a;
- Figur 9c: das Wechselsignal der Figur 3b moduliert mit dem Modulationssignal der Figur 9a;
- Figur 10a: ein Modulationssignal, das sich durch Überlagerung der Modulationssignale der Figuren 4a und 7a zusammensetzt;
- Figur 10b: das Wechselsignal der Figur 3a moduliert mit dem Modulationssignal der Figur 10a;
- Figur 10c: das Wechselsignal der Figur 3b moduliert mit dem Modulationssignal der Figur 10a;
- Figur 11a: ein erstes Modulationssignal;
- Figur 11b: ein zweites Modulationssignal;
- Figur 11c: ein Modulationssignal das durch Überlagerung der Modulationssignale der Figuren 11a und 11b erzeugt wurde;
- Figur 11d: das Wechselsignal der Figur 3a moduliert mit dem Modulationssignal der Figur 11c;
- Figur 11e: das Wechselsignal der Figur 3b moduliert mit dem Modulationssignal der Figur 11c.

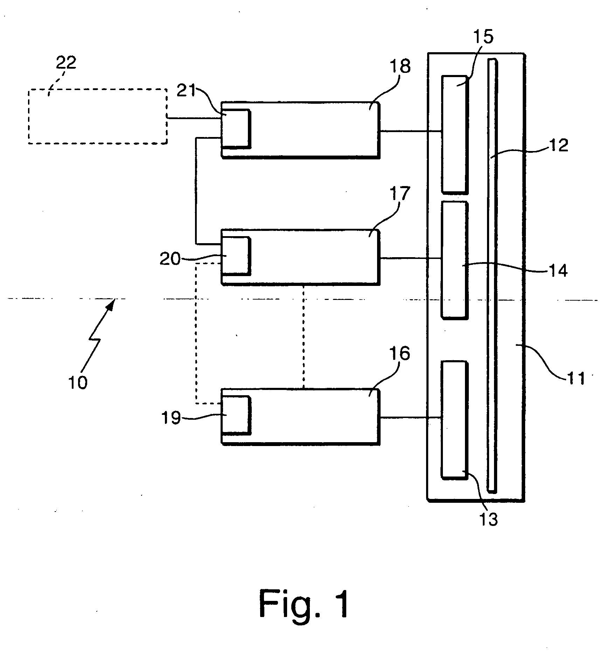

Die Figur 1 zeigt eine Plasmastromversorgung 10 in schematischer Darstellung. In einer Plasmakammer 11 ist ein Substrat 12 angeordnet, das durch mehrere Magnetrons 13, 14, 15 beschichtet wird. Ein Magnetron kann aus einer Doppelkathodenanordnung mit Magneten bestehen. Die Beschichtung des Substrats 12 soll dadurch möglichst gleichmäßig erfolgen. Im Wesentlichen wird durch jedes Magnetron 13, 14, 15 ein eigener Plasmaprozess durchgeführt. Die Magnetrons 13, 14, 15 werden jeweils durch eine Leistungsversorgungseinheit 16, 17, 18 mit Leistung versorgt. Die Leistungsversorgungseinheiten 16, 17, 18 sind sogenannte MF-Stromversorgungen. Dies bedeutet, dass sie ein Wechselsignal erzeugen, das eine Frequenz im Bereich 10 bis 500 kHz erzeugen. Wird das Wechselsignal nicht durch ein Modulationssignal moduliert, so wird dieses Wechselsignal am Ausgang zur Verfügung gestellt und werden die Magnetrons 13, 14, 15 dadurch angesteuert. Die in den einzelnen Leistungsversorgungseinheiten 16 - 18 generierten Wechselsignale können unterschiedliche Frequenzen aufweisen. Die Wechselsignale können jedoch durch ein oder mehrere Modulationssignale moduliert werden, sodass am Ausgang der Leistungsversorgungseinheiten 16, 17, 18 ein moduliertes Wechselsignal anliegt. Durch die Modulationssignale können die am Ausgang der Leistungsversorgungseinheiten 16, 17, 18 anliegenden modulierten Wechselsignale synchronisiert werden.

Die Leistungsversorgungseinheiten 16, 17, 18 weisen jeweils Modulationssignalschnittstellen 19, 20, 21 auf. Über die Modulationssignalschnittstellen 19, 20, 21 stehen die Leistungsversorgungseinheiten 16, 17, 18 miteinander in Verbindung, sodass in den Leistungsversorgungseinheiten 16, 17, 18 generierte Modulationssignale auch an die anderen Leistungsversorgungseinheiten 16, 17, 18 übergeben werden können. Weiterhin ist ein externer Modulationssignalgenerator 22 optional vorgesehen, der ein Modulationssignal erzeugen kann und zumindest einer Leistungsversorgungseinheit 16, 17, 18 zuführen kann. Durch die Serienschaltung der Leistungsversorgungseinheiten 16, 17, 18 über die Modulationsschnittstellen 19, 20, 21 kann dieses Modulationssignal, das im Modulationssignalgenerator 22 erzeugt, wurde auch an alle Leistungsversorgungseinheiten 16, 17, 18 gegeben werden.

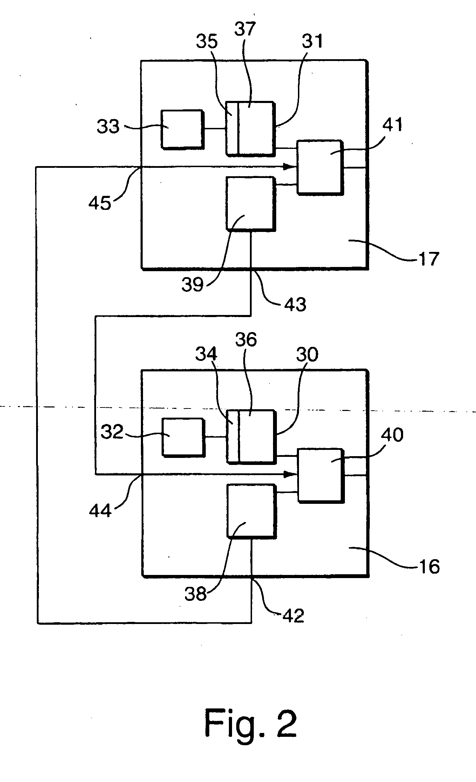

Die Figur 2 zeigt exemplarisch die Leistungsversorgungseinheiten 16, 17 in detaillierter Darstellung. Jede Leistungsversorgungseinheit 16, 17 umfasst einen Wechselsignalerzeuger 30, 31 der jeweils an eine Gleichstromversorgung 32, 33 angeschlossen ist und einen Inverter 34, 35 sowie einen Schwingkreis 36, 37 zur Erzeugung eines Wechselsignals aufweist. Weiterhin weist jede Leistungsversorgungseinheit 16, 17 einen Modulationssignalerzeuger 38, 39 auf, der eine Arcerkennungseinrichtung umfassen kann. Das Wechselsignal sowie das Modulationssignal werden an einen Modulator 40, 41 gegeben, in dem ein Ausgangssignal, insbesondere ein moduliertes Wechselsignal, erzeugt wird. Die Modulationssignalerzeuger 38, 39 stehen weiterhin jeweils mit einem Modulationssignalausgang 42, 43 in Verbindung, wobei die Modulationssignalausgänge 42, 43 jeweils mit zumindest einem Modulatiossignaleingang 44, 45 einer andere Leistungsversorgungseinheit 16, 17 verbunden sind. Die Modulationssignaleingänge 44, 45 steht wiederum mit den Modulatoren 40, 41 in Verbindung, sodass dass durch die Wechselsignalerzeuger 30, 31 generierte Wechselsignale mit den Modulationssignalen beider Modulationssignalerzeuger 38, 39 moduliert werden können. Der Modulationssignaleingang 44 und der Modulationssignalausgang 42 bilden die Schnittstelle 19 und der Modulationssignaleingang 45 und der Modulationssignalausgang 43 bilden die Schnittstelle 20.

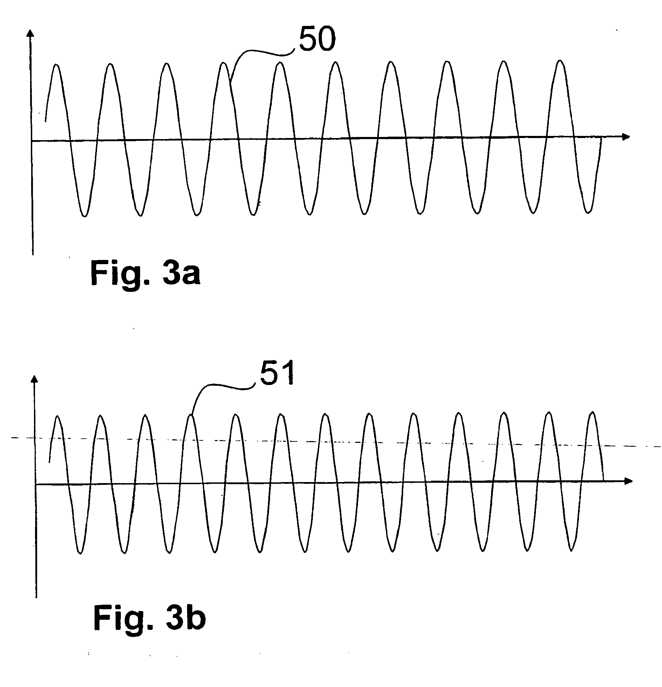

In der Figur 3a ist ein Wechselsignal 50 gezeigt, welches beispielsweise durch den Wechselsignalerzeuger 30 erzeugt wurde und eine erste Frequenz aufweist.

In der Figur 3b ist ein Wechselsignal 51 einer zweiten Frequenz gezeigt, wie es beispielsweise durch den Wechselsignalgenerator 31 erzeugt wurde. Liegt kein Modulationssignal vor, so werden die Signale 50, 51 als Ausgangssignale an die Magnetrons 13, 14 gegeben.

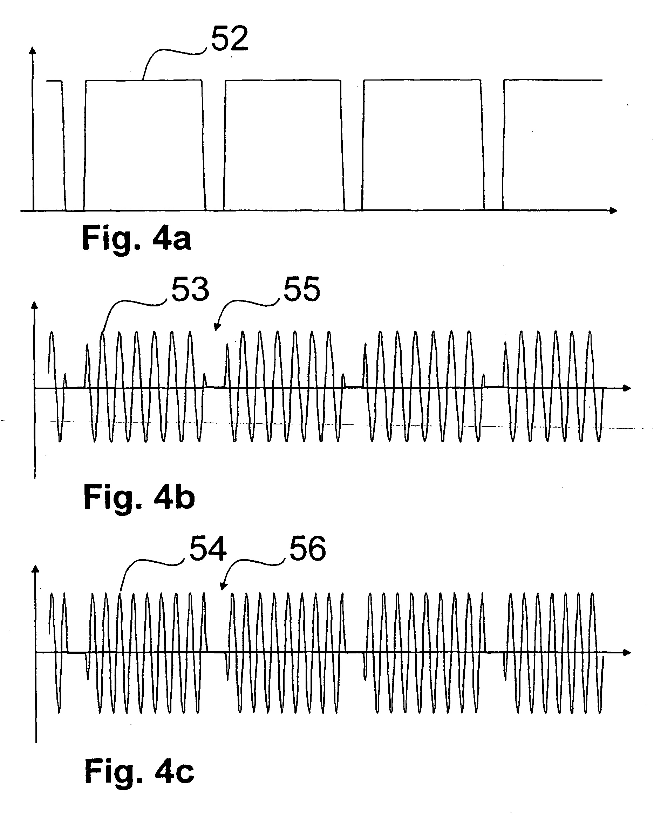

In der Figur 4a ist ein Modulationssignal gezeigt, wie es beispielsweise durch einen externen Modulationssignalgenerator 22 erzeugt wurde. Das Modulationssignal 52 ist in diesem Fall ein Pulssignal. Durch Modulation des Signals 50 mit dem Signal 52 entsteht das Signal 53, das in der Figur 4b gezeigt ist. Durch die Modulation des Wechselsignals 51 mit dem Modulationssignal 52 entstand das Signal 54, das in der Figur 4c gezeigt ist. Zu sehen ist, dass an den Stellen 55, 56 für eine kurze Zeitspanne keine Leistung an die Magnetrons 13, 14 abgegeben wird. Dies erfolgt auch zur gleichen Zeit, da durch das Modulationssignal 52 eine Synchronisation erfolgte.

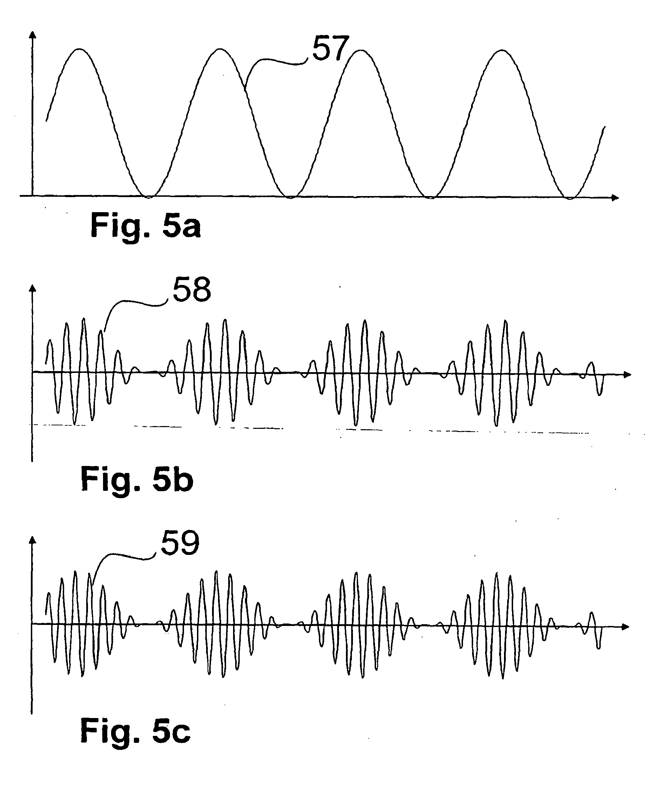

In der Figur 5a ist ein alternatives, sinusförmiges Modulationssignal 57 gezeigt. Auch dieses Signal kann beispielsweise extern vorgegeben worden sein. Eine Modulation des Signals 50 mit dem Modulationssignal 57 führt zu dem modulierten Wechselsignal 58 der Figur 5b. Entsprechend führt eine Modulation des Wechselsignals 51 mit dem Modulationssignal 57 zu dem Signal 59 der Figur 5c. Auch hier ist zu erkennen, dass die Wechselsignale 50, 51 die unterschiedliche Frequenzen aufweisen, durch das Modulationssignal 57 synchronisiert wurden. Es wird somit den Magnetrons 13, 14 synchron in ähnlicher Weise Leistung zugeführt.

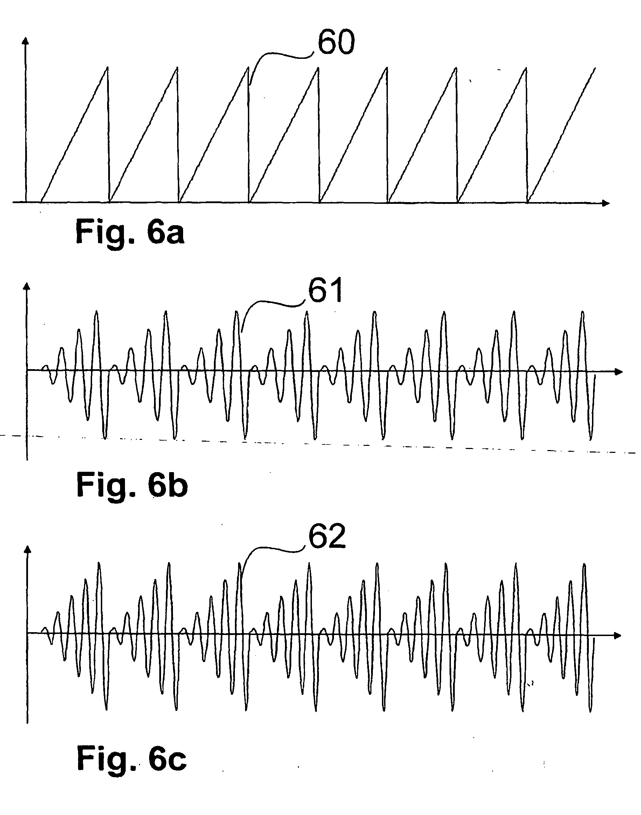

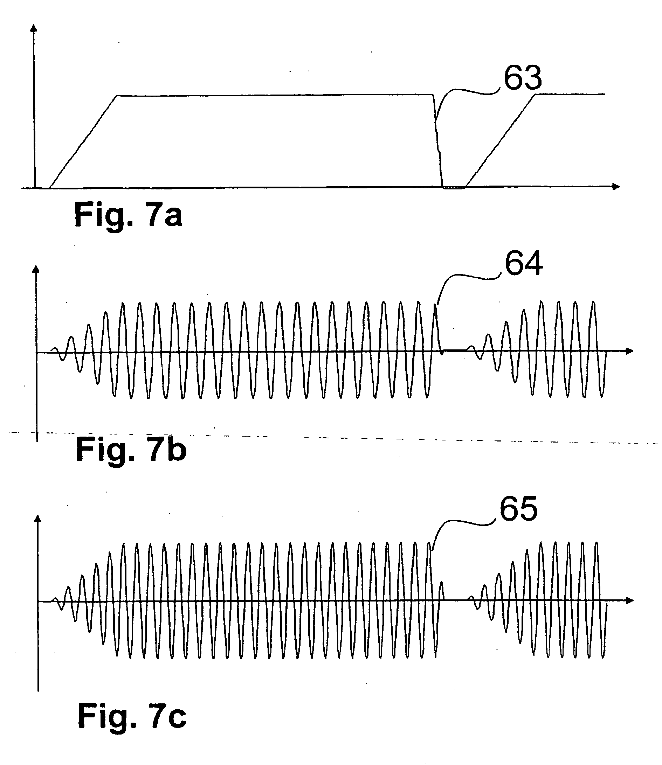

Die Figur 6a zeigt ein weiteres Modulationssignal 60. Das Signal 61 der Figur 6b wurde erzeugt, indem das Wechselsignal 50 mit dem Modulationssignal 60 moduliert wurde. Das Signal 62 der Figur 6c wurde erzeugt, indem das Wechselsignal 51 mit dem Modulationssignal 60 moduliert wurde. Ein weiteres Beispiel eines Modulationssignals 63 ist in der Figur 7a gezeigt. Wird das Wechselsignal 50 mit dem Modulationssignal 63 moduliert, so entsteht das Signal 64, das in Figur 7b gezeigt ist.

Durch Modulation des Wechselsignals 51 mit dem Modulationssignal 63 entsteht das Signal 65 der Figur 7c.

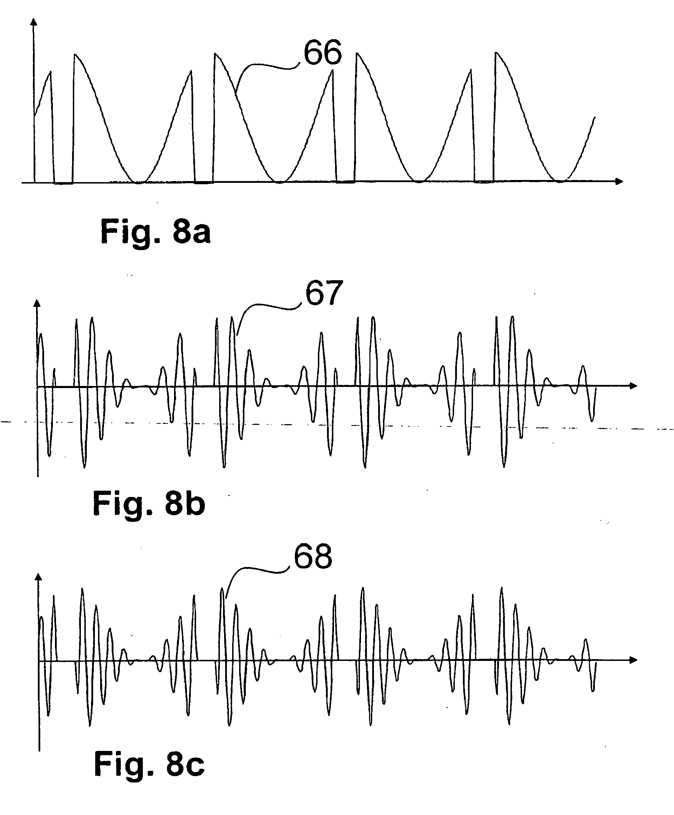

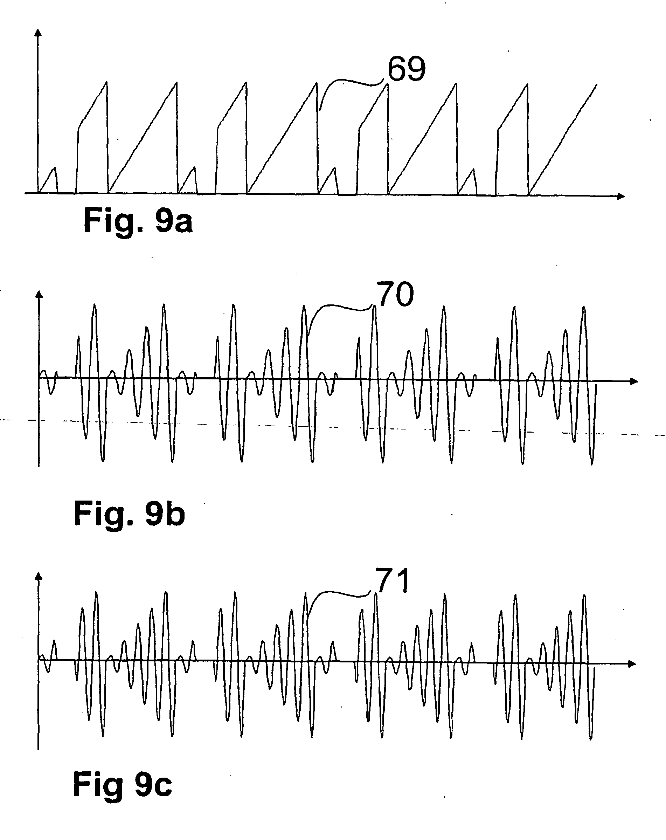

Wie sich aus der Beschreibung der Figur 2 ergibt, können einem Modulator 40, 41 auch mehrere Modulationssignale zugeführt werden. Durch eine Überlagerung der Modulationssignale 52, 57 entsteht das in Fig 8a gezeigte Modulationssignal 66. Durch die Modulation des Wechselsignals 50 mit dem Modulationssignal 66 entsteht das in Figur 8b gezeigte Signal 67. Entsprechend entsteht das Signal 68 der Figur 8c durch Modulation des Wechselsignals 51 mit dem Modulationssignal 66. Eine Überlagerung der Modulationssignale 52 und 60 führt zu dem Modulationssignal 69 der Figur 9a. Eine Modulation des Wechselsignals 50 mit diesem Signal führt zu dem Signal 70 der Figur 9b und eine Modulation des Wechselsignals 51 mit dem Signal 61 führt zu dem Signal 71 der Figur 9c.

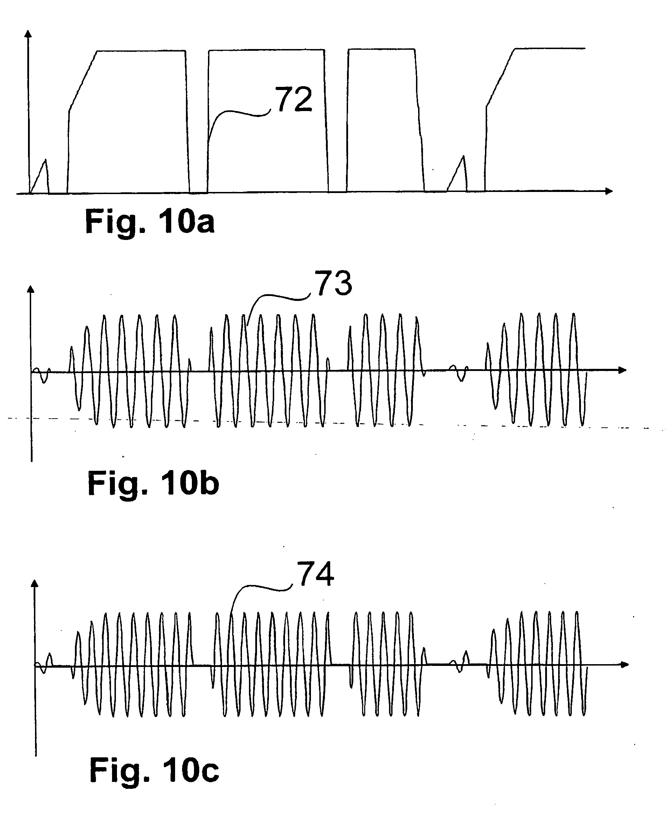

Die Figur 10a trägt ein Modulationssignal 72, das durch Überlagerung der Modutationssignale 52 und 63 entstanden ist. Eine Modulation des Wechselsignals 50 mit diesem Signal führt zu dem Signal 73 der Figur 10b und eine Modulation des Signals 51 mit dem Signal 72 führt zu dem Signal 74 der Figur 10c.

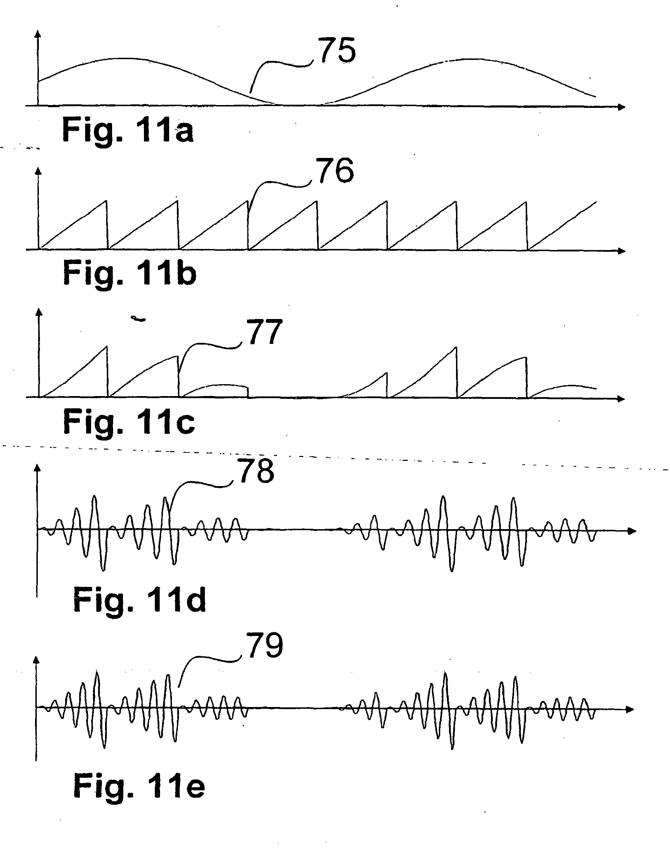

Die Figur 11a zeigt ein Modulationssignal, wie es beispielsweise durch den Modulationssignalgenerator 38 erzeugt wurde und ist mit der Bezugsziffer 75 bezeichnet.

Die Figur 11b zeigt ein Modulationssignal, wie es beispielsweise durch den Modulationssignalgenerator 39 erzeugt wurde. Das Signal ist mit der Bezugsziffer 76 bezeichnet. Die Signale 75, 76 werden sowohl dem Modulator 40 als auch dem Modulator 41 zugeführt, so dass das resultierende Modulationssignal 77 entsteht. Eine Modulation des Wechselsignals 50 mit dem Modulationssignal 77 führt zu dem Signal 78 und eine Modulation des Wechselsignal 51 mit dem Signal 77 führt zu dem Signal 79. Auch hier ist zu erkennen, dass die Signal 78, 79 zueinander synchronisiert sind. Weiterhin zeigen die Figuren 11a bis 11e, dass eine Leistungsversorgungseinheit 16, 17 ihr Modulationssignal einer anderen Leistungsversorgungseinheit 16, 17 aufzwingen kann.

## Patentansprüche

1. Plasmaleistungsversorgungsanordnung (10) mit mehreren Leistungsversorgungseinheiten (16 - 18), die jeweils umfassen:
a. einen Wechselsignalerzeuger (30, 31),
b. einen Modulator (40, 41), der ein von dem Wechselsignalerzeuger (30, 31) erzeugtes Wechselsignal (50, 51) mit zumindest einem Modulationssignal (52, 57, 60, 63, 66, 69, 72, 75, 76) moduliert,
c. einen Modulationssignaleingang (44, 45), der mit dem Modulator (40, 41) in Verbindung steht,
d. einen Modulationssignalausgang (42, 43), der mit zumindest einem Modulationssignaleingang (44, 45) einer anderen Leistungsversorgungseinheit in Verbindung steht.

2. Plasmaleistungsversorgungsanordnung nach Anspruch 1, **dadurch gekennzeichnet, dass** in jeder Leistungsversorgungseinheit (16 - 18) ein Modulationssignalerzeuger (38, 39, 22) vorgesehen ist, der mit dem Modulator (40, 41) und/oder dem Modulationssignalausgang (42, 43) in Verbindung steht.

3. Plasmaleistungsversorgungsanordnung nach einem der vorhergehenden Ansprüche, **dadurch gekennzeichnet, dass** der Modulationssignalausgang (42, 43) und der Modulationssignaleingang (44, 45) einer Leistungsversorgungseinheit (16 - 18) in einer Schnittstelle (19 - 21) realisiert sind.

4. Plasmaleistungsversorgungsanordnung nach einem der vorhergehenden Ansprüche, **dadurch gekennzeichnet, dass** die Wechselsignalerzeuger (30, 31) als Freischwinger ausgebildet sind.

5. Plasmaleistungsversorgungsanordnung nach einem der vorhergehenden Ansprüche, **dadurch gekennzeichnet, dass** die Leistungsversorgungseinheiten (16 - 18) über die Modulationssignaleingänge und -ausgänge (42 - 45) in Serie miteinander verbunden sind.

6. Plasmaleistungsversorgungsanordnung nach einem der vorhergehenden Ansprüche, **dadurch gekennzeichnet, dass** jede Leistungsversorgungseinheit (16 - 18) an eine Doppelkathodeneinheit (13 - 15) angeschlossen ist.

7. Plasmaleistungsversorgungsanordnung nach einem der vorhergehenden Ansprüche, **dadurch gekennzeichnet, dass** zumindest ein Modulationssignalerzeuger (38, 39) eine Arcerkennungseinrichtung umfasst oder mit einer solchen verbunden ist.

8. Verfahren zum Betrieb einer Plasmaleistungsversorgungsanordnung (10) mit mehreren Leistungsversorgungseinheiten (16 - 18), wobei in jeder Leistungsversorgungseinheit (16 - 18)
a. ein Wechselsignal (50, 51) erzeugt wird,
b. das erzeugte Wechselsignal (50, 51) mit zumindest einem Modulationssignal (52, 57, 60, 63, 66, 69, 72, 75, 76) moduliert wird,
c. wobei als Modulationssignal (52, 57, 60, 63, 66, 69, 72, 75, 76) ein in der jeweiligen Leistungsversorgungseinheit erzeugtes Modulationssignal (52, 57, 60, 63, 66, 69, 72, 75, 76) und/oder ein extern erzeugtes Modulationssignal (52, 57, 60, 63, 66, 69, 72, 75, 76) verwendet wird.

9. Verfahren nach Anspruch 8, **dadurch gekennzeichnet, dass** ein in einer Leistungsversorgungseinheit (16 - 18) erzeugtes Modulationssignal (52, 57, 60, 63, 66, 69, 72, 75, 76) zumindest einer anderen Leistungsversorgungseinheit (16 - 18) zugeführt wird.

10. Verfahren nach Anspruch 8 oder 9, **dadurch gekennzeichnet, dass** ein in einer Leistungsversorgungseinheit (16 - 18) erzeugtes Modulationssignal (52, 57, 60, 63, 66, 69, 72, 75, 76) allen anderen Leistungsversorgungseinheiten (16 - 18) zugeführt wird.

11. Verfahren nach Anspruch 10, **dadurch gekennzeichnet, dass** jede Leistungsversorgungseinheit (16 - 18) ein Modulationssignal (52, 57, 60, 63, 66, 69, 72, 75, 76) erzeugt, das jeweils allen anderen Leistungsversorgungseinheiten (16 - 18) zugeführt wird.

12. Verfahren nach einem der vorhergehenden Ansprüche 8 bis 11, **dadurch gekennzeichnet, dass** in zumindest einer Leistungsversorgungseinheit (16 - 18) ein moduliertes Ausgangssignal erzeugt wird, indem das Wechselsignal (50, 51) mit einem intern generierten und einem extern generierten Modulationssignal (52, 57, 60, 63, 66, 69, 72, 75, 76) moduliert wird.

13. Verfahren nach einem der vorhergehenden Ansprüche 8 bis 12, **dadurch gekennzeichnet, dass** durch jede Leistungsversorgungseinheit (16 - 18) ein Wechselsignal (50, 51) mit einer Frequenz im Bereich 10kHz - 500kHz und einer Leistung > 50kW erzeugt wird.

14. Verfahren nach einem der vorhergehenden Ansprüche 8 bis 13, **dadurch gekennzeichnet, dass** in jeder Leistungsversorgungseinheit (16 - 18) ein Wechselsignal (50, 51) mit einer anderen Frequenz erzeugt wird.

15. Verfahren nach einem der vorhergehenden Ansprüche 8 bis 14, **dadurch gekennzeichnet, dass** in zumindest einer Leistungsversorgungseinheit (16 - 18) eine Arcerkennung durchgeführt wird.

## Claims

1. Plasma power supply arrangement (10) having a plurality of power supply units (16-18), each of which comprises:
a. an alternating signal generator (30, 31),
b. a modulator (40, 41) which modulates an alternating signal (50, 51) generated by the alternating signal generator (30, 31) with at least one modulating signal (52, 57, 60, 63, 66, 69, 72, 75, 76),
c. a modulating signal input (44, 45) which is connected to the modulator (40, 41),
d. a modulating signal output (42, 43) which is connected to at least one modulating signal input (44, 45) of a different power supply unit.

2. Plasma power supply arrangement according to claim 1, **characterised in that** a modulating signal generator (38, 39, 22) is provided in each power supply unit (16-18), which modulating signal generator (38, 39, 22) is connected to the modulator (40, 41) and/or to the modulating signal output (42, 43).

3. Plasma power supply arrangement according to any one of the preceding claims, **characterised in that** the modulating signal output (42, 43) and the modulating signal input (44, 45) of a power supply unit (16-18) are provided in an interface (19-21).

4. Plasma power supply arrangement according to any one of the preceding claims, **characterised in that** the alternating signal generators (30, 31) are in the form of free-running oscillators.

5. Plasma power supply arrangement according to any one of the preceding claims, **characterised in that** the power supply units (16-18) are connected in series to one another by way of the modulating signal inputs and outputs (42-45).

6. Plasma power supply arrangement according to any one of the preceding claims, **characterised in that** each power supply unit (16-18) is connected to a double cathode unit (13-15).

7. Plasma power supply arrangement according to any one of the preceding claims, **characterised in that** at least one modulating signal generator (38, 39) comprises an arc detection device or is connected to such a device.

8. Method of operating a plasma power supply arrangement (10) having a plurality of power supply units (16-18), wherein in each power supply unit (16-18)
a. an alternating signal (50, 51) is generated,
b. the alternating signal (50, 51) that has been generated is modulated with at least one modulating signal (52, 57, 60, 63, 66, 69, 72, 75, 76),
c. wherein there is used as the modulating signal (52, 57, 60, 63, 66, 69, 72, 75, 76) a modulating signal (52, 57, 60, 63, 66, 69, 72, 75, 76) generated in the power supply unit in question and/or an externally generated modulating signal (52, 57, 60, 63, 66, 69, 72, 75, 76).

9. Method according to claim 8, **characterised in that** a modulating signal (52, 57, 60, 63, 66, 69, 72, 75, 76) generated in a power supply unit (16-18) is fed to at least one other power supply unit (16-18).

10. Method according to claim 8 or 9, **characterised in that** a modulating signal (52, 57, 60, 63, 66, 69, 72, 75, 76) generated in a power supply unit (16-18) is fed to all the other power supply units (16-18).

11. Method according to claim 10, **characterised in that** each power supply unit (16-18) generates a modulating signal (52, 57, 60, 63, 66, 69, 72, 75, 76) which is fed to all the other power supply units (16-18).

12. Method according to any one of the preceding claims 8 to 11, **characterised in that** a modulated output signal is generated in at least one power supply unit (16-18) by modulation of the alternating signal (50, 51) with an internally generated and an externally generated modulating signal (52, 57, 60, 63, 66, 69, 72, 75, 76).

13. Method according to any one of the preceding claims 8 to 12, **characterised in that** an alternating signal (50, 51) with a frequency in the range of from 10 kHz to 500 kHz and a power > 50 kW is generated by each power supply unit (16-18).

14. Method according to any one of the preceding claims 8 to 13, **characterised in that** an alternating signal (50, 51) with a different frequency is generated in each power supply unit (16-18).

15. Method according to any one of the preceding claims 8 to 14, **characterised in that** an arc detection is carried out in at least one power supply unit (16-18).

## Revendications

1. Dispositif d'alimentation en puissance pour plasmas (10) comprenant plusieurs unités d'alimentation en puissance (16 - 18) qui comportent chacune :
a. un générateur de signaux alternatifs (30, 31),
b. un modulateur (40, 41) qui module un signal alternatif (50, 51) généré par le générateur de signaux alternatifs (30, 31) par au moins un signal de modulation (52, 57, 60, 63, 66, 69, 72, 75, 76),
c. une entrée de signal de modulation (44, 45) qui est reliée au modulateur (40, 41),
d. une sortie de signal de modulation (42, 43) qui est reliée à au moins une entrée de signal de modulation (44, 45) d'une autre unité d'alimentation en puissance.

2. Dispositif d'alimentation en puissance pour plasmas selon la revendication 1, **caractérisé en ce qu'**il est prévu dans chaque unité d'alimentation en puissance (16 - 18) un générateur de signaux de modulation (38, 39, 22) qui est relié au modulateur (40,41) et/ou à la sortie de signal de modulation (42, 43).

3. Dispositif d'alimentation en puissance pour plasmas selon une des revendications précédentes, **caractérisé en ce que** la sortie de signal de modulation (42, 43) et l'entrée de signal de modulation (44, 45) d'une unité d'alimentation en puissance (16 - 18) sont réalisées dans une interface (19 - 21).

4. Dispositif d'alimentation en puissance pour plasmas selon une des revendications précédentes, **caractérisé en ce que** les générateurs de signaux alternatifs (30, 31) sont réalisés sous la forme d'oscillateurs libres.

5. Dispositif d'alimentation en puissance pour plasmas selon une des revendications précédentes, **caractérisé en ce que** les unités d'alimentation en puissance (16 - 18) sont reliées entre elles en série par les entrées et sorties de signal de modulation (42 - 45).

6. Dispositif d'alimentation en puissance pour plasmas selon une des revendications précédentes, **caractérisé en ce que** chaque unité d'alimentation en puissance (16 - 18) est raccordée à une unité à double cathode (13 - 15).

7. Dispositif d'alimentation en puissance pour plasmas selon une des revendications précédentes, **caractérisé en ce qu'**au moins un générateur de signaux de modulation (38, 39) comprend un dispositif de détection d'arcs ou est relié à un tel dispositif.

8. Procédé pour faire fonctionner un dispositif d'alimentation en puissance pour plasmas (10) comprenant plusieurs unités d'alimentation en puissance (16 - 18), dans chacune desquelles unités d'alimentation en puissance (16 - 18)
a. un signal alternatif (50, 51) est généré,
b. le signal alternatif (50, 51) généré est modulé par au moins un signal de modulation (52, 57, 60, 63, 66, 69, 72, 75, 76),
c. un signal de modulation (52, 57, 60, 63, 66, 69, 72, 75, 76) généré dans l'unité d'alimentation en puissance respective et/ou un signal de modulation (52, 57, 60, 63, 66, 69, 72, 75, 76) généré de manière externe étant utilisé comme signal de modulation (52, 57, 60, 63, 66, 69, 72, 75, 76).

9. Procédé selon la revendication 8, **caractérisé en ce qu'**un signal de modulation (52, 57, 60, 63, 66, 69, 72, 75, 76) généré dans une unité d'alimentation en puissance (16 - 18) est amené à au moins une autre unité d'alimentation en puissance (16 - 18).

10. Procédé selon la revendication 8 ou 9, **caractérisé en ce qu'**un signal de modulation (52, 57, 60, 63, 66, 69, 72, 75, 76) généré dans une unité d'alimentation en puissance (16 - 18) est amené à toutes les autres unités d'alimentation en puissance (16 - 18).

11. Procédé selon la revendication 10, **caractérisé en ce que** chaque unité d'alimentation en puissance (16 - 18) génère un signal de modulation (52, 57, 60, 63, 66, 69, 72, 75, 76) qui est amené à toutes les autres unités d'alimentation en puissance (16 - 18).

12. Procédé selon une des revendications précédentes 8 à 11, **caractérisé en ce qu'**un signal de sortie modulé est généré dans au moins une unité d'alimentation en puissance (16 - 18) en modulant le signal alternatif (50, 51) par un signal de modulation (52, 57, 60, 63, 66, 69, 72, 75, 76) généré de manière interne et un signal de modulation (52, 57, 60, 63, 66, 69, 72, 75, 76) généré de manière externe.

13. Procédé selon une des revendications précédentes 8 à 12, **caractérisé en ce que** chaque unité d'alimentation en puissance (16 - 18) génère un signal alternatif (50, 51) d'une fréquence comprise entre 10 kHz et 500 kHz et d'une puissance supérieure à 50 kW.

14. Procédé selon une des revendications précédentes 8 à 13, **caractérisé en ce qu'**un signal alternatif (50, 51) d'une autre fréquence est généré dans chaque unité d'alimentation en puissance (16 - 18).

15. Procédé selon une des revendications précédentes 8 à 14, **caractérisé en ce qu'**une détection d'arcs est effectuée dans au moins une unité d'alimentation en puissance (16 - 18).
